# EUROPÄISCHE PATENTANMELDUNG

(11) **EP 4 685 275 A1**
(43) Veröffentlichungstag der Anmeldung: **28.01.2026**
(21) Anmeldenummer: 25191270.5
(22) Anmeldetag: 23.07.2025
(51) Int. Cl.: C30B 29/20

(54) **VERFAHREN UND VORRICHTUNG ZUR HERSTELLUNG EINES SAPHIR-EINKRISTALLS SOWIE SAPHIR-EINKRISTALL**

(30) Priorität: 23.07.2024 AT 506072024
(71) Anmelder: FAMETEC GmbH, 4060 Leonding (AT)
(72) Erfinder: EBNER, Robert, 4060 Leonding (AT); PARK, Jongkwan, 4060 Leonding (AT); SEN, Gourav, 4060 Leonding (AT); LOHRASBI, Sina, 4060 Leonding (AT); BÜRSCHER, Martin, 4030 Linz (AT); SAMHABER, Georg, 4073 Wilhering (AT)
(74) Vertreter: Burger, Hannes Alfred

(57) **Zusammenfassung**

Die Erfindung betrifft einen Saphir-Einkristall (4) sowie ein Verfahren und eine Vorrichtung (1) zu dessen herstellen, wobei der Saphir-Einkristall (4) eine Mehrzahl von, in einer C-Achse (7) aneinandergereihten Schichten (11) umfasst, wobei jede Schicht (11) eine Querschnittstopografie (12) aufweist, wobei sich Querschnittstopografien (12) der Schichten (11) in Bezug auf, in den Querschnittstopografien (12) ausgebildete geometrisches Muster (13) wiederholen, wobei die geometrischen Muster (13) überwiegend aus polygonalen Ringen, insbesondere aus konzentrischen, hexagonalen oder konzentrischen hexagonalen Ringen, zusammengesetzt sind.

## Beschreibung

Die Erfindung betrifft einen Saphir-Einkristall und eine Vorrichtung und ein Verfahren zur Herstellung desselben.

Synthetisch hergestellte einkristalline Werkstoffe haben ein breites Feld an technischen Anwendungen. Je nach der Art des Werkstoffs eignen sich unterschiedliche Methoden zur Herstellung der entsprechenden Einkristalle. Dazu muss das üblicherweise polykristallin vorliegende Ausgangs- bzw. Rohmaterial (Pulver oder Granulat) einer Umkristallisation unterzogen werden. Die Herstellungsverfahren lassen sich nach den Phasenübergängen, die zu dem Einkristall führen, unterscheiden. Diese können eine Züchtung aus der Schmelze, aus der Lösung oder aus der Gasphase sein. Ein sogenannter Impfkristall bzw. ein Keimkristall bildet dabei die Basis für die Anlagerung weiterer Lagen von aus Atomen gebildeten Gitterebenen des Kristallgitters. Bei der Züchtung eines Einkristalls aus einer Schmelze muss dazu das Ausgangsmaterial in einem Tiegel eines entsprechenden Ofens über seine Schmelztemperatur erhitzt und somit verflüssigt werden. Zur Auskristallisation der Schmelze an dem Keimkristall muss die Temperatur langsam genug unter den Schmelzpunkt sinken. Der Keimkristall wird dazu durch Kühlung geringfügig unterhalt der Schmelztemperatur gehalten.

Für technisch-industrielle Anwendungen besonders bedeutsam sind Einkristalle aus Saphir. Diese können synthetisch aus geschmolzenem Aluminiumoxid (Al₂O₃) hergestellt werden. Saphir ist säurebeständig und wird wegen seiner hohen Kratzfestigkeit beispielsweise als sogenanntes Saphirglas für Uhrengläser oder als kratzfestes Display von Smartphones eingesetzt.

In dem Dokument WO 2013112231 A1 wird ein Verfahren zur Herstellung eines kristallinen Erzeugnisses mit einem hohen Volumenanteil an monokristallinem Material in einem Kristallwachstumskammer offenbart. Das Verfahren umfasst die Herstellung eines Tiegels mit Ausgangsmaterial und mindestens einem monokristallinen Keimkristall, das Schmelzen des Ausgangsmaterials, ohne den monokristallinen Keimkristall wesentlich zu schmelzen, und die Bildung des kristallinen Erzeugnisses durch Erstarrung der Schmelze ebenfalls unter kontrollierten Bedingungen.

Das Dokument AT 524249 A1 beschreibt eine Vorrichtung zum Züchten von Einkristallen aus Siliziumcarbid, umfassend einen Tiegel mit einem Aufnahmeraum mit einer Axialerstreckung zwischen einem Bodenabschnitt und einem Öffnungsabschnitt. In dem Aufnahmeraum der Vorrichtung ist eine Keimkristallschicht angeordnet, wobei diese aus mehreren Keimkristallplatten mosaikartig zusammengesetzt ist.

Das Dokument JP H11268989 A beschreibt ein Verfahren zur Herstellung von SiC-Einkristallen, durch das auf einfachere Weise und mit höherer Effizienz SiC-Einkristalle hergestellt werden können sollen. Ein Keim-Kristall, der für eine Gasphasenmethode wie eine Sublimationsmethode verwendet wird, besteht aus dem Zusammenschluss mehrerer SiC-Einkristalle. Diese werden auf der gleichen Oberfläche so angeordnet, dass die Richtungen ihrer Wachstumsflächen und die Richtungen der Kristalle auf der Oberfläche zusammenfallen und sich kein Raum zwischen den SiC-Einkristallen bildet. Auf diese Art gelingt es, den Durchmesser des Einkristalls zu vergrößern.

Das Dokument AT 524605 A1 betrifft ein Verfahren zur Herstellung eines Saphir-Einkristalls, wobei eine Prozesskammer und ein Tiegel mit einem Impfkristall sowie mit einem Basismaterial und mit eine Heizvorrichtung vorgesehen werden. Bei dem Verfahren ist weiters das Spülen der Prozesskammer mittels eines Gases und das anschließende Abpumpen des Gases zum Einstellen eines Prozessdruckes vorgesehen. Das Kristallwachstums wird durch Wärmeabfuhr bewirkt, wobei außerdem ein Feuchtegehalt des abgepumpten Gases bestimmt wird.

Aufgabe der vorliegenden Erfindung war es, eine Vorrichtung und ein Verfahren zur Herstellung von Kristallen mit verbesserten Eigenschaften und somit einen Saphir-Einkristall mit verbesserten Eigenschaften zu schaffen.

Diese Aufgabe wird durch eine Vorrichtung und ein Verfahren gemäß den Ansprüchen gelöst.

Die Erfindung betrifft einen Saphir-Einkristall, umfassend eine Mehrzahl von, in einer C-Achse aneinandergereihten Schichten, wobei der Saphir-Einkristall aus Schmelze aus einem Ausgangsmaterial aus Aluminiumoxid Al₂O₃ und durch Rekristallisation des Ausgangsmaterials an einem Keimkristall durch ein Wachstumsverfahren in einem dafür vorgesehenen Tiegel hergestellt ist, wobei jede Schicht eine Querschnittstopografie aufweist, wobei die Querschnittstopografie durch das Wachstumsverfahren des Saphir-Einkristalls bedingt ist, wobei sich Querschnittstopografien der Schichten in Bezug auf, in den Querschnittstopografien ausgebildete geometrisches Muster wiederholen, wobei die Größe und/oder Anzahl von geometrischen Mustern und/oder die Orientierung von geometrischen Mustern in Bezug auf eine Rotation um die C-Achse veränderbar sind.

Unter Schicht ist im Zusammenhang mit der Erfindung eine Querschnittsschicht durch den Saphir-Einkristall zu verstehen, wobei die C-Achse des Saphir-Einkristalls als Normalachse einer jeweiligen Schicht ausgerichtet ist. Im gleichen Sinne ist der im weiteren Verlauf verwendete Begriff Temperaturschicht in Bezug auf die Ausrichtung einer Temperaturschicht relativ zum Saphir-Einkristall zu verstehen. Der Saphir-Einkristall wird in einem dafür vorgesehenen Tiegel durch ein Wachstumsverfahren gezüchtet bzw. hergestellt. Der Tiegel hat Seitenwände, einen Boden, der vorzugsweise von einem Saphir-Keimkristall gebildet ist, und dementsprechend einen Höhenerstreckung. Die C-Achse des Saphir-Einkristalls erstreckt sich dabei in Richtung der Höhenerstreckung des Tiegels, wobei die durch das Wachstumsverfahren bestimmte Wachstumsrichtung des Saphir-Einkristalls der C-Achse entspricht.

Des Weiteren kann es zweckmäßig sein, wenn die geometrischen Muster überwiegend aus polygonalen Ringen, insbesondere aus konzentrischen, hexagonalen oder konzentrischen hexagonalen Ringen, zusammengesetzt sind.

Unter einem geometrischen Mustern ist im Zusammenhang mit der Erfindung der Begriff Versetzungen im Hinblick auf Mineralografie und eine zugehörige Anordnung von Kristallgittern in Schichten zu verstehen. Unter Versetzungen kann in diesem Zusammenhang verstanden werden, dass sich diese durch Gitterdefekte, Atomverschiebungen, Gitterverzerrungen, Gleitlinien, plastische Verformungen auf Grund des Kristallisationsprozesses bei der Herstellung, andere Deformationsmechanismen oder Materialdefekte oder Dotierungen einstellen. In diesem Sinne können die geometrischen Muster aus konzentrischen hexagonalen Ringen als hexagonalförmige Versetzungen bezeichnet bzw. angesehen werden, wobei diese hexagonalförmigen Versetzungen insbesondere auch konzentrisch um die C-Achse des Keimkristalls ausgebildet sein können.

Ein derartiges geometrisches Muster als Teil einer Querschnittstopografie einer Schicht des Saphir-Einkristalls kann beispielsweise durch eine geeignete Messvorrichtung für das menschliche Auge erkennbar dargestellt werden. Dabei wird eine Schicht des Saphir-Einkristalls mit Strahlung und vorzugsweise mit Röntgenstrahlung bestrahlt. Die Messvorrichtung umfasst einen Detektor der relativ zur bestrahlten Sicht außerhalb der Verlängerung der Strahlung positioniert ist, sodass am Detektor nur von der Schicht abgelenkte Strahlen auftreffen und so detektiert werden. Auf diese Weise kann mittels des Detektors eine Darstellung erstellt werden, die Versetzungen im Gitter der Scheibe aus Saphir-Einkristall erkennbar macht. Das Verfahren, durch welches derartige Versetzungen bzw. die geometrischen Muster der Querschnittstopografie einer Scheibe aus Saphir-Einkristall sichtbar gemacht werden können, kann auch als Röntgentopografie bezeichnet werden, wobei dabei jedenfalls ein Intensitätsprofil der vom Kristall gebeugten Röntgenstrahlung ausgewertet und für das menschliche Auge sichtbar dargestellt wird. Das mittels dieses Verfahrens darstellbare topographische Bild zeigt folglich die Regelmäßigkeit oder Unregelmäßigkeit des Kristallgitters anhand der gebeugten Intensität. Somit ist die Querschnittstopografie bestimmt, die eine regionale und einfache Information einer Probe wie etwa der Scheibe aus Saphir-Einkristall liefern kann.

Im Hinblick auf Schichten eines Einkristalls bezieht sich der Begriff Querschnittstopografie auf die dreidimensionale Anordnung und Beschaffenheit der Kristallschichten. Anders als bei polykristallinen Materialien, die aus vielen kleinen, unregelmäßig orientierten Kristallen bestehen, hat ein Einkristall eine überwiegend durchgehende, geordnete Gitterstruktur. Diese Struktur kann jedoch durch verschiedene Defekte und Verunreinigungen gestört werden. Die Topografie eines Einkristalls kann daher Informationen über folgende Aspekte der Kristallschichten liefern: Dicke der Schichten, Oberflächenrauhigkeit, Defekte wie z.B. Versetzungen oder Korngrenzen oder Verunreinigungen. Die Kenntnis der Topografie eines Einkristalls ist für die Herstellung und Verwendung von Halbleitern, LEDs und anderen Materialien, die aus Einkristallen bestehen, von großer Bedeutung. Die Informationen über die Kristallschichten können dazu verwendet werden, die Eigenschaften des Materials zu optimieren und seine Leistung zu verbessern.

Computerchips oder andere Halbleiterprodukte werden unter anderem mittels chemischer Gasphasenabscheidung vorkonditioniert, hergestellt oder wenigstens teilweise hergestellt. Während der metallorganische chemische Gasphasenabscheidung (MOCVD) verformt sich ein Substrat aufgrund der komplexen Spannungen, die durch das Epitaxiewachstum bei hohen Temperaturen entstehen, auf vielfältige Weise. Die Verformung ist dabei vom Grundmaterial des Substrats, also im vorliegenden Beispiel von den Eigenschaften des Saphir-Einkristalls, aus welchem ein Substrat hergestellt ist, abhängig. Verformt sich ein Substrat möglichst homogen und vielleicht sogar eher sphärisch als multimodal, ist dies für die Prozessentwicklung und die Prozessführung bei der MOCVD hilfreich. Verformt sich der Wafer dagegen auf komplexe Weise (z. B. multimodal, wie ein Kartoffelchip), ist es schwierig, die Wiederholbarkeit und Reproduzierbarkeit der MOCVD zu gewährleisten, was zu einem erhöhten Ausschuss bei der Computerchip-Herstellung oder sogar zu einer Verringerung einer möglichen Komplexität von Computerchips führen kann. So bietet der erfindungsgemäße Saphir-Einkristall den Vorteil, dass insbesondere hexagonale geometrische Muster in der Querschnittstopografie eine definierte Verformung bei weiterer Bearbeitung einer Schicht des Saphir-Einkristalls bedingen.

Unter einem Wachstumsverfahren ist im Sinne der Erfindung insbesondere der McSAP-Prozess (Multi C-Axis Sapphire Process) zu verstehen, welcher ein innovatives Verfahren zur Herstellung von monokristallinem Saphir ist, das sich von herkömmlichen Methoden wie dem Kyropolous-Verfahren (KY) durch mehrere Vorteile abhebt. Das Kernprinzip des McSAP-Prozesses ist es, dass im Gegensatz zum KY-Verfahren, das nur entlang der a-Achse des Saphirkristalls wächst, ermöglicht ist, dass der McSAP-Prozess das gleichzeitige Wachstum mehrerer Kristalle entlang der c-Achse ermöglicht und begünstigt. Dies wird durch die Verwendung eines speziellen Ofens und einer optimierten Wachstumsführung erreicht. Der Prozessablauf des McSAP-Prozesses umfasst die folgenden Schritte: Zunächst werden hochreine polykristalline Saphirmaterialien als Ausgangsmaterial aufbereitet; Das Ausgangsmaterial wird in einem Tiegel unter kontrollierten Bedingungen geschmolzen, um eine homogene Schmelze zu erzeugen; Die geschmolzene Saphirphase dient als Nährlösung für das Wachstum der Kristalle; Durch gezielte Temperatur- und Druckregelung sowie die Zufuhr von Dotierstoffen werden die Kristalle entlang der c-Achse gezüchtet; Nach Abschluss des Wachstumsvorgangs werden die fertig gezüchteten Saphirkristalle aus dem Ofen entnommen und weiterverarbeitet. Der McSAP-Prozess bietet unter anderem die Vorteile einer höheren Materialausbaute an Ausgangsmaterial, einer verbesserten Energieeffizienz und einer erhöhten Qualität der damit hergestellten Saphir-Einkristalle.

Unter dem Begriff Wachstumsverfahren ist somit im Sinne der Erfindung ein Verfahren zur Herstellung von zumindest einem einkristallinen Kristall, insbesondere von einem Saphir, zu verstehen, wobei ein einkristalliner Keimkristall in einem Bodenbereich des Tiegels mit einer zylindermantelförmigen Tiegelwand angeordnet wird oder einen Boden des Tiegels bildet und eine kristallographische C-Achse des Keimkristalls entsprechend einer sich in Richtung der Höhe der Tiegelwand erstreckende Längsachse des Tiegels ausgerichtet wird, worauf über dem Keimkristall in dem Tiegel ein Ausgangsmaterial angeordnet und aufgeschmolzen wird, wobei ein Kristallwachstum durch Kristallisation an einer Grenzschicht zwischen aufgeschmolzenen Ausgangsmaterial und Keimkristall in Richtung der C-Achse fortschreitend erfolgt.

Ferner kann vorgesehen sein, dass das Wachstumsverfahren eine, mittels Heizvorrichtung durch Temperaturschichten und Temperaturbereiche beeinflusste Rekristallisation der Schmelze im Tiegel und eine, mit einem Wachstum des Saphir-Einkristalls in Richtung der C-Achse mitgeführte Veränderung der Temperaturschichten und der Temperaturbereiche umfasst. Es kann dabei auch vorgesehen sein, dass die Heizvorrichtung auch zur selektiven und/oder lokalen Kühlung ausgebildet ist. Jedenfalls kann so der Wachstumsprozess des Saphir-Einkristalls in geeigneter Weise und durch diese einfache Maßnahme gesteuert werden.

Darüber hinaus kann vorgesehen sein, dass eine Temperaturschicht in einem Wachstumsbereich des Saphir-Einkristalls während dem Wachstumsverfahren mehrere, in einem Polygon angeordnete, im Speziellen in einem Hexagon angeordnete, und relativ zu deren Umgebung wärmere Temperaturbereich aufweist, wobei die wärmeren Temperaturbereiche insbesondere ringförmig und innerhalb des Saphir-Einkristalls angeordnet sind. Dadurch ist die Ausbildung der geometrischen Muster begünstigt.

Die Erfindung betrifft weiters noch eine Vorrichtung zur Herstellung eines künstlichen Saphir-Einkristalls, umfassend einen Tiegel mit einem Keimkristall oder zur Aufnahme eines Keimkristalls und zur Aufnahme von Ausgangsmaterial aus Aluminiumoxid Al₂O₃, eine Heizvorrichtung zur Erwärmung des Tiegels, insbesondere zur lokal selektiven Erwärmung des Tiegels, wobei unter der Heizvorrichtung auch eine Vorrichtung zu verstehen ist, mittels welcher der Tiegel gekühlt oder im Speziellen lokal selektiv gekühlt werden kann, und eine Steuervorrichtung zur Temperatursteuerung und/oder -kontrolle des Tiegels und/oder im Tiegel mittels der Heizvorrichtung, wobei die Heizvorrichtung mittels der Steuervorrichtung derart ansteuerbar ist, dass bei einem Wachstumsverfahren des Saphir-Einkristalls aus Schmelze des Ausgangsmaterials in Querschnittstopografien von Schichten des Saphir-Einkristalls sich wiederholende geometrische Muster ausbildbar sind, wobei während dem Wachstumsverfahren insbesondere eine, mit einem Wachstum des Saphir-Einkristalls in Richtung der C-Achse mitgeführte Veränderung der Temperaturschichten und der Temperaturbereiche im Saphir-Einkristall einstellbar ist. Mittels der erfindungsgemäßen Vorrichtung ist auf einfache Weise ein Saphir-Einkristall mit den vorhergehend beschriebenen vorteilhaften Eigenschaften herstellbar.

Darüber hinaus kann vorgesehen sein, dass sich Querschnittstopografien der Schichten in Bezug auf, in den Querschnittstopografien ausgebildete geometrisches Muster wiederholen, wobei die Größe und/oder Anzahl von geometrischen Mustern und/oder die Orientierung von geometrischen Mustern in Bezug auf eine Rotation um die C-Achse veränderbar sind. Dadurch ist gewährleistet, dass eine Vielzahl der Schichten des Saphir-Einkristalle die vorhergehend beschriebenen vorteilhaften Eigenschaften aufweisen.

Des Weiteren kann vorgesehen sein, dass die geometrischen Muster überwiegend aus polygonalen Ringen, insbesondere aus konzentrischen, hexagonalen oder konzentrischen hexagonalen Ringen, zusammengesetzt ist. Dadurch ist eine definierte Verformung von Schichten des Saphir-Einkristalle bei deren weiterer Verwendung bei der Computerchip-Herstellung erreichbar, sodass derartige Saphir-Einkristalle hochwertig sind.

Gemäß einer besonderen Ausprägung ist es möglich, dass die Heizvorrichtung derart ausgebildet und/oder mittels der Steuervorrichtung ansteuerbar ist, dass eine Temperaturschicht in einem Wachstumsbereich des Saphir-Einkristalls beim Wachstumsverfahren mehrere, in einem Polygon angeordnete, im Speziellen in einem Hexagon angeordnete, und relativ zu deren Umgebung warme Temperaturbereiche aufweist, wobei die warmen Temperaturbereiche insbesondere ringförmig und innerhalb des Saphir-Einkristalls angeordnet sind. Somit sind die geometrischen Muster auf möglichst einfache Weise herstellbar.

Entsprechend einer vorteilhaften Weiterbildung kann vorgesehen sein, dass die Heizvorrichtung ein selektiv beheizbares oder kühlbares Heizelement umfasst, wobei das Heizelement in einem Innenraum des Tiegels ausgehend von einem ersten Bereich oberhalb der Schmelze aus Ausgangsmaterial bis in einen zweiten Bereich unterhalb einer Oberfläche der Schmelze aus Ausgangsmaterial absenkbar ist, sodass die Temperaturschichten und/oder die Temperaturbereiche mittels des Heizelements beeinflussbar sind. Dadurch kann ist die Beeinflussbarkeit der geometrischen Muster weiter verbessert.

Unter einem Heizelement ist im Sinne der Erfindung ein Heiz- und Kühlelement zu verstehen, da die Schmelze im Tiegel mittels des Heizelements selektiv heiz- und kühlbar sein kann.

Die Erfindung betrifft weiters noch ein Verfahren zur Herstellung eines Saphir-Einkristalls durch Züchtung aus einer Schmelze aus einem Ausgangsmaterial, wobei an einem Boden eines Tiegels ein Keimkristall angeordnet wird und darüber das Ausgangsmaterial in den Tiegel gefüllt wird, wobei das Ausgangsmaterial im Speziellen Aluminiumoxid Al₂O₃ in stückiger, granularer oder pulverförmiger Beschaffenheit umfasst, und das Ausgangsmaterial bis zur Bildung der Schmelze erhitzt wird und anschließend durch ein Wachstumsverfahren als Teilverfahren des erfindungsgemäßen Verfahrens eine Rekristallisation des Ausgangsmaterials an dem Keimkristall herbeigeführt wird, wobei während dem Wachstumsverfahren Temperaturschichten und Temperaturbereiche im Saphir-Einkristall mittels einer Heizvorrichtung des Tiegels derart eingestellt werden, dass eine Temperaturschicht in einem Wachstumsbereich des Saphir-Einkristalls mehrere, in einem Polygon angeordnete, im Speziellen in einem Hexagon angeordnete, und relativ zu deren Umgebung wärmere Temperaturbereiche aufweist, wobei die wärmeren Temperaturbereiche insbesondere ringförmig und innerhalb des Saphir-Einkristalls angeordnet sind. Durch das erfindungsgemäße Verfahren ist auf einfache Weise ein Saphir-Einkristall mit den vorhergehend beschriebenen vorteilhaften Eigenschaften herstellbar.

Insbesondere kann es vorteilhaft sein, wenn die Heizvorrichtung ein selektiv beheizbares oder kühlbares Heizelement umfasst, wobei das Heizelement während dem Wachstumsverfahren in einen Innenraum des Tiegels ausgehend von einem ersten Bereich oberhalb der Schmelze des Ausgangsmaterials bis in einen zweiten Bereich unterhalb einer Oberfläche der Schmelze des Ausgangsmaterials abgesenkt wird, sodass die Temperaturschichten und/oder die Temperaturbereiche mittels des Heizelements beeinflusst werden. Dadurch kann ist die Beeinflussbarkeit der geometrischen Muster weiter verbessert.

Zum besseren Verständnis der Erfindung wird diese anhand der nachfolgenden Figuren näher erläutert.

Es zeigen jeweils in stark vereinfachter, schematischer Darstellung:
- Fig. 1: eine Vorrichtung zur Herstellung eines künstlichen Saphir-Einkristalls, in Ansicht geschnitten;
- Fig. 2: eine Messvorrichtung für eine Querschnittstopografie einer Schicht des Saphir-Einkristalls;
- Fig. 3: eine Temperaturschicht und eine zugehörige Querschnittstopografie einer Schicht des Saphir-Einkristalls.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

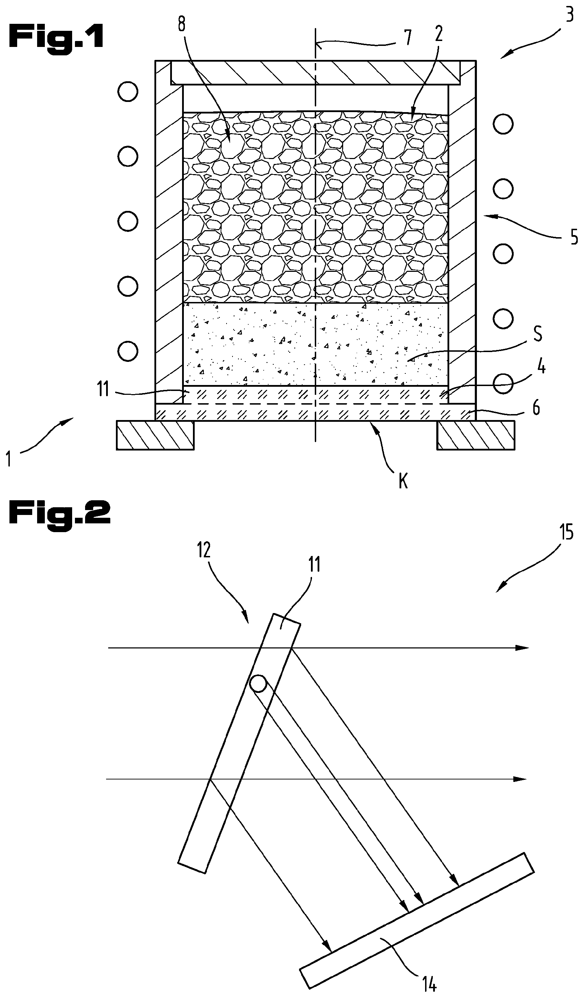

In der Fig. 1 ist eine Vorrichtung 1 gezeigt, welche zum Züchten eines Kristalls, insbesondere eines künstlich hergestellten Saphir-Kristalls K, dient bzw. dazu ausgebildet ist. Saphir hat die chemische Formel Al₂O₃, kommt in der Natur vor und wird unter anderem als Schmuckstein oder dergleichen verwendet.

Die synthetische oder künstliche Herstellung erfolgt ausgehend von einem sogenannten Ausgangsmaterial 2, welches eine stückige, körnige bis hin zu einer pulverförmigen Struktur aufweisen kann. Es können auch größere Stücke zur Erreichung einer besseren Fülldichte verwendet werden. Das Ausgangsmaterial 2 wird in eine allgemein als Tiegel 3 bezeichnete Aufnahmevorrichtung oder Aufnahme-gefäß eingebracht und dort mittels Wärmezufuhr in bekannter Weise aufgeschmolzen.

Die Schmelze, welche nachfolgend mit dem Buchstaben "S" bezeichnet wird, wird abgekühlt oder kühlt sich ab und dabei erfolgt die Erstarrung und Bildung des Saphir-Kristalls K. Bei einem derartigen Saphir-Kristall K handelt es sich bevorzugt um eine Einkristall-Form von Aluminiumoxid (Al₂O₃). Der synthetisch hergestellte Saphir-Kristall K, also der Saphir-Einkristall 4 weist einen Härtewert von 9 auf der Mohs-Skala auf. Darüber hinaus weisen daraus hergestellte Produkte, wie z.B. Wafer, Uhrgläser, Gehäuse, Leuchtdioden oder dergleichen, eine hohe Kratzfestigkeit auf. Bevorzugt werden Saphir-Kristalle K mit glasklaren Eigenschaften oder aber auch je nach Zusatzstoff mit farbigem Aussehen gebildet.

Die Vorrichtung 1, bzw. der Tiegel 3 umfasst eine Tiegelwand 5, welche ihrerseits einen ersten Endbereich im Bereich eines Deckels und einen davon beabstandet angeordneten zweiten Endbereich im Bereich des Saphir-Einkristalls 4 aufweist. Der Saphir-Einkristall wird durch ein Wachstumsverfahren innerhalb des Tiegels 3 auf einem Keimkristall 6, welcher gleichzeitig den Boden des Tiegels 3 bilden kann, künstlich hergestellt. Zwischen den beiden Endbereichen erstreckt sich eine Längsachse, welche einer sogenannten C-Achse 7 des Saphir-Einkristalls 4 entsprechen kann. Der Tiegel 3 ist in einem Ofen angeordnet und kann mittels einer Heizvorrichtung erwärmt werden. Es sei an dieser Stelle der Vollständigkeit halber erwähnt, dass die Vorrichtung 1 noch weitere Elemente umfasst, wie z.B. eine Steuervorrichtung, etc. Da diese aber dem Stand der Technik entsprechen können, wird in dieser Beschreibung nicht weiter darauf eingegangen.

Bei diesem Ausführungsbeispiel ist der erste Endbereich des Tiegels 3 geschlossen ausgebildet. Es sind jedoch auch Ausführungsformen denkbar, bei welchen der erste Endbereich des Tiegels 3 offen ausgebildet ist, indem kein Deckel vorgesehen ist. Der zweite Endbereich bildet bei lotrechter Ausrichtung der Längsachse bzw. der C-Achse 7 den bodenseitigen Endabschnitt aus und ist gänzlich offen oder zu einem überwiegenden Anteil offen ausgebildet. Die Tiegelwand 5 ist grundsätzlich rohrförmig ausgebildet und kann die unterschiedlichsten Querschnittformen bezüglich der Längsachse bzw. der C-Achse 7 aufweisen. Die Querschnittsform hängt vom Querschnitt des herzustellenden Saphir-Einkristalls 4 ab. So kann der Innenquerschnitt z.B. rund, oval oder mehreckig ausgebildet sein. Der mehreckige Querschnitt kann z.B. von einem Quadrat, einem Rechteck, einem Fünfeck, Sechseck, Achteck oder dergleichen gebildet sein.

Die Tiegelwand 5 definiert ihrerseits eine Tiegelwand-Innenfläche und eine Tiegelwand-Außenfläche, wobei in radialer Richtung gesehen von den beiden Tiegelwand-Flächen eine Tiegelwanddicke festgelegt wird.

Zur Bildung eines Aufnahmeraums bzw. eines Innenraums 8 ist die Tiegelwand 5 bodenseitig in ihrem zweiten Endbereich mit einem Tiegelboden verschlossen auszubilden. Damit definieren die Tiegelwand 5 und der Tiegelboden den Aufnahmeraum bzw. den Innenraum 8, wobei der Tiegelboden mittels dem Keimkristall 6 gebildet sein kann.

Es ist bei diesem Ausführungsbeispiel und auch bei den nachfolgend beschriebenen Ausführungsbeispielen vorgesehen, dass der Tiegelboden selbst zu seinem überwiegenden Anteil ausschließlich aus einer Platte aus einem bereits zuvor künstlich hergestellten Saphir-Kristall K bzw. dem Keimkristall 6 gebildet ist oder wird. Bevorzugt ist jedoch der gesamte Tiegelboden ausschließlich von der Platte aus dem bereits zuvor künstlich hergestellten Saphir-Kristall K bzw. dem Keimkristall 6 gebildet. Es wurde jeweils die Trennlinie zwischen der Platte und dem bereits neu hergestellten Saphir- Einkristall 4 mit einer strichlierten Linie dargestellt, da am Beginn des Aufschmelzvorgangs des Ausgangsmaterial 2 und der Bildung der Schmelze S die dem Innenraum 8 zugewendete Oberfläche der Platte zumindest teilweise oder gänzlich aufgeschmolzen wird und bei fortschreitender Abkühlung und Kristallisation ein zusammengehöriger einstückiger Saphir-Kristall K bzw. Saphir-Einkristall 4 ausgebildet wird.

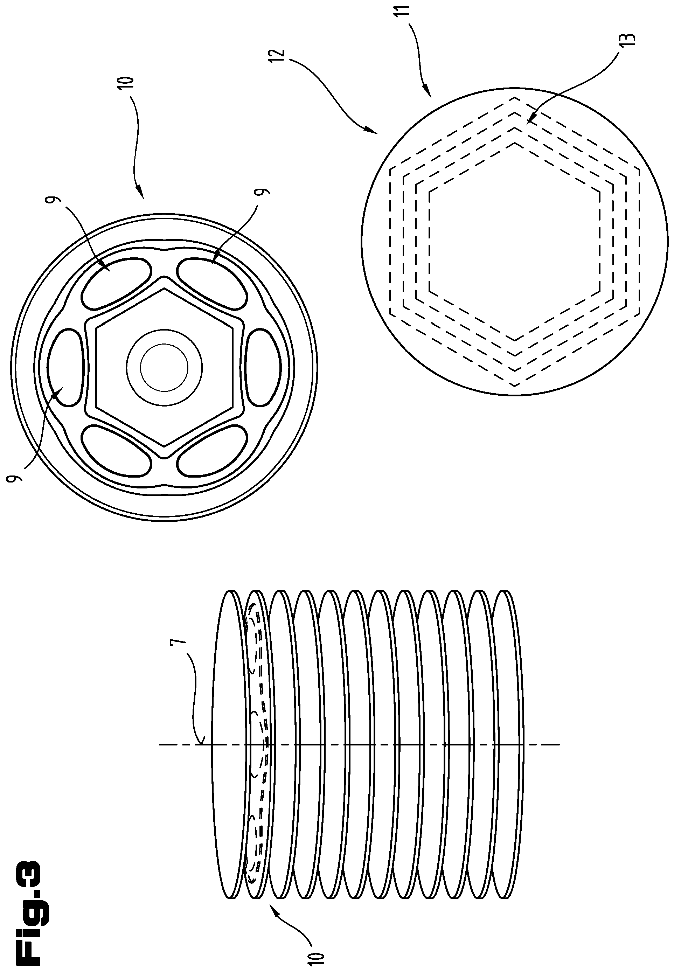

Die Heizvorrichtung zum Heizen des Tiegels kann beispielsweise eine Widerstandsheizung mit einer Spule, wie diese in Fig. 1 angedeutet ist, umfassen. Es kann aber auch vorgesehen sein, dass die Heizvorrichtung mehrere und in Richtung der C-Achse 7 verlaufend ausgebildete Spulen umfasst, sodass der Tiegel selektiv bzw. zonenweise beheizbar ist. Es kann dabei vorgesehen sein, dass derartige Spulen mehrfach und um den Tiegel herum angeordnet sind. Jedenfalls ist eine Heizvorrichtung für den Tiegel derart ausgebildet, dass bestimmungsgemäße Temperaturbereiche 9 und Temperaturschichten 10 (vgl. Fig. 3) eingestellt werden können.

Der Saphir-Einkristall 4 kann gedanklich in einzelne Schichten 11 unterteilt werden. Eine Schicht 11 ist dabei vorzugsweise derart ausgerichtet, dass die C-Achse 7 des Saphir-Einkristalls 4 als Normalachse zur Schicht 11 ausgerichtet ist. Im gleichen Sinne ist die Ausrichtung einer Temperaturschicht 10, wie diese in Fig. 3 dargestellt ist, zu verstehen. Jedenfalls wird ein Saphir-Einkristall 4 der vorliegenden Erfindung mit einem speziellen Wachstumsverfahren hergestellt bzw. gezüchtet, indem die Heizvorrichtung mit einer Steuervorrichtung derart angesteuert wird, dass sich bestimmungsgemäße Temperaturbereiche 9 und Temperaturschichten 10 (vgl. Fig. 3) einstellen, sodass sich in den Schichten 11 des Saphir-Einkristalls 4 spezielle Querschnittstopografien 12 einstellen (vgl. Fig. 2 und Fig. 3). Die speziellen Querschnittstopografien 12 weisen bei erfindungsgemäßem Saphir-Einkristall 4 geometrische Muster 13 (vgl. Fig. 3) auf, welche sich innerhalb einer Querschnittstopografie 12 und auch in jeder weiteren Querschnittstopografie 12 einer weiteren Schicht 11 wiederholen können. Die geometrischen Muster 13 können dabei in Größe und Anzahl oder bezüglich deren Rotation um die C-Achse 7 in den einzelnen Schichten 11 eines Saphir-Einkristalls 4 variieren.

Was in diesem Zusammenhang unter einem geometrischen Muster zu verstehen ist, kann der genauen Ausführung und Definition dieses Begriffs in der Beschreibungseinleitung entnommen werden.

Vorzugsweise umfassen die geometrischen Muster 13 in den Querschnittstopografien 12 des Saphir-Einkristalls 4 überwiegend polygonale und insbesondere konzentrische hexagonale Ringe. Dies hat den Vorteil, dass bei weiterer Verwendung von einzelnen Schichten 11 des Saphir-Einkristalls 4, insbesondere bei Verwendung derselben als Basismaterial zur Halbleiter- bzw. Chip-Produktion, Verformung der Schichten 11 in vorwiegend definierten Formen passieren und unter Umständen auch gegenüber anderen Verformungsbilder minimiert sein können.

Um die in der Beschreibungseinleitung vorhergegangene Definition des Begriffs der geometrischen Muster 13 zu vervollständigen, wird nachfolgend beschrieben, wie diese geometrischen Muster 13 sichtbar gemacht werden können. Dazu zeigt Fig. 2 eine Messvorrichtung 15 für eine Querschnittstopografie 12 einer Schicht 11 des Saphir-Einkristalls 4 in stark vereinfachter und schematischer Darstellung.

Bei einer derartigen Messvorrichtung 15 wird eine Schicht 11 eines Saphir-Einkristalls 4 mit Strahlung bestrahlt. Die Messvorrichtung 15 umfasst weiters auch noch einen Detektor 14 der im Nahbereich der Schicht 11 des Saphir-Einkristalls 4 positioniert ist, wobei der Detektor 14 nicht zwingen direkt im Strahlungsbereich der Strahlung positioniert ist, sodass mittels des Detektors 14 nur jene Strahlen der Strahlung detektiert werden, die von der Schicht 11 des Saphir-Einkristalls 4 in Richtung des Detektors 14 abgelenkt wurden. Auf diese Weise kann mittels des Detektors 14 eine bildgebende Darstellung der geometrischen Muster der Schicht 11 des Saphir-Einkristalls 4 erstellt werden, wobei diese Darstellung einer Darstellung der Querschnittstopografie 12 dieser Schicht 11 des Saphir-Einkristalls 4 entspricht. Unter einem geometrischen Muster 13 ist in diesem Zusammenhang der Begriff Versetzungen im Hinblick auf Mineralografie und zugehörige Anordnung von Kristallgittern in Schichten zu verstehen. Unter Versetzungen kann in diesem Zusammenhang verstanden werden, dass sich diese durch Gitterdefekte, Atomverschiebungen, Gitterverzerrungen, Gleitlinien, plastische Verformungen auf Grund des Kristallisationsprozesses bei der Herstellung, andere Deformationsmechanismen oder Materialdefekte oder Dotierungen einstellen. In diesem Sinne können die geometrischen Muster 13 aus konzentrischen hexagonalen Ringen als hexagonalförmige Versetzungen mittels der Messvorrichtung 15 dargestellt werden, wobei diese hexagonalförmigen Versetzungen im vorliegenden Fall insbesondere auch konzentrisch um die C-Achse des Keimkristalls ausgebildet sein können.

In diesem Zusammenhang ist in Fig. 3 rechterhand eine derartige Darstellung der Querschnittstopografie 12 einer Schicht 11 des Saphir-Einkristalls 4 gezeigt. Bei dieser Darstellung sind die geometrischen Muster 13 als hexagonale Ringe deutlich erkennbar.

Die Fig. 3 zeigt weiters auch noch einzelne Temperaturschichten 10 des Saphir-Einkristalls 4, wobei eine Temperaturschicht 10, welche zur rechterhand dargestellten Querschnittstopografie 12 einer Schicht 11 des Saphir-Einkristalls 4 korrespondiert, dargestellt ist. Es ist zu erkennen, dass diese Temperaturschicht 10 die bestimmungsgemäßen Temperaturbereiche 9 im Saphir-Einkristall 4, die durch entsprechende Ansteuerung der Heizvorrichtung einstellbar sind, aufweist, sodass sich durch das Wachstumsverfahren des künstlich hergestellten Saphir-Einkristalls 4 schließlich die bestimmungsgemäße Querschnittstopografie 12 mit geometrischen Mustern 13 einstellt.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 1: Vorrichtung
- 2: Ausgangsmaterial
- 3: Tiegel
- 4: Saphir-Einkristall
- 5: Tiegelwand
- 6: Keimkristall
- 7: C-Achse
- 8: Innenraum
- 9: Temperaturbereich
- 10: Temperaturschicht
- 11: Schicht
- 12: Querschnittstopografie
- 13: Geometrisches Muster
- 14: Detektor
- 15: Messvorrichtung

## Patentansprüche

1. Saphir-Einkristall (4), umfassend eine Mehrzahl von, in einer C-Achse (7) aneinandergereihten Schichten (11), wobei der Saphir-Einkristall (4) aus Schmelze aus einem Ausgangsmaterial (2) aus Aluminiumoxid Al₂O₃ und durch Rekristallisation des Ausgangsmaterials (2) an einem Keimkristall (6) durch ein Wachstumsverfahren in einem dafür vorgesehenen Tiegel (3) hergestellt ist, wobei jede Schicht (11) eine Querschnittstopografie (12) aufweist, wobei die Querschnittstopografie (12) durch das Wachstumsverfahren des Saphir-Einkristalls (4) bedingt ist,
**dadurch gekennzeichnet, dass**
sich Querschnittstopografien (12) der Schichten (11) in Bezug auf, in den Querschnittstopografien (12) ausgebildete geometrisches Muster (13) wiederholen, wobei die Größe und/oder Anzahl von geometrischen Mustern (13) und/oder die Orientierung von geometrischen Mustern (13) in Bezug auf eine Rotation um die C-Achse (7) veränderbar sind.

2. Saphir-Einkristall (4) nach Anspruch 1, **dadurch gekennzeichnet, dass** die geometrischen Muster (13) überwiegend aus polygonalen Ringen, insbesondere aus konzentrischen, hexagonalen oder konzentrischen hexagonalen Ringen, zusammengesetzt sind.

3. Saphir-Einkristall (4) nach einem der vorhergehenden Ansprüche, **dadurch gekennzeichnet, dass** das Wachstumsverfahren eine, mittels Heizvorrichtung durch Temperaturschichten (10) und Temperaturbereiche (9) beeinflusste Rekristallisation der Schmelze im Tiegel (3) und eine, mit einem Wachstum des Saphir-Einkristalls (4) in Richtung der C-Achse (7) mitgeführte Veränderung der Temperaturschichten (10) und der Temperaturbereiche (9) umfasst.

4. Saphir-Einkristall (4) nach Anspruch 3, **dadurch gekennzeichnet, dass** eine Temperaturschicht (10) in einem Wachstumsbereich des Saphir-Einkristalls (4) während dem Wachstumsverfahren mehrere, in einem Polygon angeordnete, im Speziellen in einem Hexagon angeordnete, und relativ zu deren Umgebung wärmere Temperaturbereich aufweist, wobei die wärmeren Temperaturbereiche (9) insbesondere ringförmig und innerhalb des Saphir-Einkristalls (4) angeordnet sind.

5. Vorrichtung (1) zur Herstellung eines künstlichen Saphir-Einkristalls (4), umfassend einen Tiegel (3) mit einem Keimkristall (6) oder zur Aufnahme eines Keimkristalls (6) und zur Aufnahme von Ausgangsmaterial (2) aus Aluminiumoxid Al₂O₃, eine Heizvorrichtung zur Erwärmung des Tiegels (3) und eine Steuervorrichtung zur Temperatursteuerung und/oder -kontrolle des Tiegels (3) und/oder im Tiegel (3) mittels der Heizvorrichtung, **dadurch gekennzeichnet, dass**
die Heizvorrichtung mittels der Steuervorrichtung derart ansteuerbar ist, dass bei einem Wachstumsverfahren des Saphir-Einkristalls (4) aus Schmelze des Ausgangsmaterials (2) in Querschnittstopografien (12) von Schichten (11) des Saphir-Einkristalls (4) sich wiederholende geometrische Muster (13) ausbildbar sind, wobei während dem Wachstumsverfahren insbesondere eine, mit einem Wachstum des Saphir-Einkristalls (4) in Richtung der C-Achse (7) mitgeführte Veränderung der Temperaturschichten (10) und der Temperaturbereiche (9) im Saphir-Einkristall (4) einstellbar ist.

6. Vorrichtung (1) nach Anspruch 5, **dadurch gekennzeichnet, dass** die Heizvorrichtung derart ausgebildet und/oder mittels der Steuervorrichtung ansteuerbar ist, dass eine Temperaturschicht (10) in einem Wachstumsbereich des Saphir-Einkristalls (4) beim Wachstumsverfahren mehrere, in einem Polygon angeordnete, im Speziellen in einem Hexagon angeordnete, und relativ zu deren Umgebung warme Temperaturbereiche (9) aufweist, wobei die warmen Temperaturbereiche (9) insbesondere ringförmig und innerhalb des Saphir-Einkristalls (4) angeordnet sind.

7. Vorrichtung (1) nach einem der Ansprüche 5 oder 6, **dadurch gekennzeichnet, dass** die Heizvorrichtung ein selektiv beheizbares oder kühlbares Heizelement umfasst, wobei das Heizelement in einem Innenraum (8) des Tiegels (3) ausgehend von einem ersten Bereich oberhalb der Schmelze aus Ausgangsmaterial (2) bis in einen zweiten Bereich unterhalb einer Oberfläche der Schmelze aus Ausgangsmaterial (2) absenkbar ist, sodass die Temperaturschichten (10) und/oder die Temperaturbereiche (9) mittels des Heizelements beeinflussbar sind.

8. Verfahren zur Herstellung eines Saphir-Einkristalls (4) durch Züchtung aus einer Schmelze aus einem Ausgangsmaterial (2), wobei an einem Boden eines Tiegels (3) ein Keimkristall (6) angeordnet wird und darüber das Ausgangsmaterial (2) in den Tiegel (3) gefüllt wird, wobei das Ausgangsmaterial (2) im Speziellen Aluminiumoxid Al₂O₃ in stückiger, granularer oder pulverförmiger Beschaffenheit umfasst, und das Ausgangsmaterial (2) bis zur Bildung der Schmelze erhitzt wird und anschließend durch ein Wachstumsverfahren eine Rekristallisation des Ausgangsmaterials (2) an dem Keimkristall (6) herbeigeführt wird,
**dadurch gekennzeichnet, dass**
während dem Wachstumsverfahren Temperaturschichten (10) und Temperaturbereiche (9) im Saphir-Einkristall (4) mittels einer Heizvorrichtung des Tiegels (3) derart eingestellt werden, dass eine Temperaturschicht (10) in einem Wachstumsbereich des Saphir-Einkristalls (4) mehrere, in einem Polygon angeordnete, im Speziellen in einem Hexagon angeordnete, und relativ zu deren Umgebung wärmere Temperaturbereiche (9) aufweist, wobei die wärmeren Temperaturbereiche (9) insbesondere ringförmig und innerhalb des Saphir-Einkristalls (4) angeordnet sind.

9. Verfahren nach Anspruch 8, **dadurch gekennzeichnet, dass** die Heizvorrichtung ein selektiv beheizbares oder kühlbares Heizelement umfasst, wobei das Heizelement während dem Wachstumsverfahren in einen Innenraum (8) des Tiegels (3) ausgehend von einem ersten Bereich oberhalb der Schmelze des Ausgangsmaterials (2) bis in einen zweiten Bereich unterhalb einer Oberfläche der Schmelze des Ausgangsmaterials (2) abgesenkt wird, sodass die Temperaturschichten (10) und/oder die Temperaturbereiche (9) mittels des Heizelements beeinflusst werden.
